# FASCICULE DE BREVET EUROPEEN

(11) **EP 2 494 695 B1**
(45) Date de publication et mention de la délivrance du brevet: **21.11.2018**
(21) Numéro de dépôt: 10774187.8
(22) Date de dépôt: 27.10.2010
(51) Int. Cl.: H03M 1/18

(54) **SYSTEME ET PROCEDE DE COMMANDE D'UN CAPTEUR NUMERIQUE**
SYSTEM UND VERFAHREN ZUM STEUERUNG EINES DIGITALEN SENSORS
SYSTEM AND METHOD FOR CONTROLLING A DIGITAL SENSOR

(30) Priorité: 27.10.2009 FR 0957541
(43) Date de publication de la demande: 05.09.2012
(73) Titulaire: Movea, 38000 Grenoble (FR)
(72) Inventeur: RICCARDI, Sébastien, F-38590 Brezins (FR)
(74) Mandataire: Brunelli, Gérald
(86) Numéro de dépôt international: PCT/EP2010/066244
(87) Numéro de publication internationale: WO 2011/051328

(56) Documents cités:
- JP-A- 60 053 325
- US-A1- 2008 291 067
- US-B1- 7 405 683

## Description

La présente invention porte sur un système et un procédé de commande d'un capteur numérique.

Un capteur est un système qui transforme une première grandeur physique observée en une deuxième grandeur physique utilisable, comme une tension électrique, une hauteur de mercure, une intensité de courant électrique, une déviation d'aiguille,... Le capteur est une interface entre un processus physique et une information manipulable.

Le capteur est à différentier de l'appareil de mesure, qui est un appareil autonome, disposant d'un affichage ou d'un dispositif de stockage des données, ce qui n'est pas forcément le cas du capteur. Les capteurs sont les éléments de base des systèmes d'acquisition de données.

Les capteurs peuvent être classés de différentes manières.

Par exemple, ils peuvent être distingués par leur consommation énergétique, en capteurs passifs ou capteurs actifs.

Un capteur passif est un capteur qui ne nécessite pas d'apport d'énergie extérieure pour fonctionner, par exemple une thermistance, un potentiomètre, ou un thermomètre à mercure. Un capteur passif est modélisable par une impédance. Une variation du phénomène physique mesuré engendre une variation de l'impédance. Un capteur actif est, en revanche, un capteur qui nécessite un apport d'énergie extérieure pour fonctionner, par exemple un chronomètre mécanique, une jauge d'extensométrie appelée aussi jauge de contrainte, ou un gyromètre. Un capteur actif est modélisable par des générateurs comme les dispositifs photovoltaïques et électromagnétiques. Ainsi, un capteur actif génère soit un courant électrique, soit une tension électrique en fonction de l'intensité du phénomène physique mesuré.

Les capteurs peuvent également faire l'objet d'une classification par type de sortie, en capteurs analogiques et capteurs numériques.

Le signal de sortie d'un capteur analogique est un signal analogique, tel une tension électrique ou un courant électrique, tandis que le signal de sortie d'un capteur numérique est un signal numérique, tel un train d'impulsions, un code numérique binaire ou un bus de terrain.

Un capteur est généralement caractérisé par plusieurs critères tels la grandeur physique mesurée, la plage de fonctionnement, ou la précision. Pour utiliser un capteur dans les meilleures conditions, il est souvent utile de pratiquer un étalonnage et de connaître les incertitudes de mesures relatives à celui-ci.

Un capteur numérique comprend un transducteur délivrant en sortie un signal analogique représentatif de la grandeur physique mesurée. Un transducteur est un dispositif transformant une grandeur physique en une autre, i.e on obtient en sortie du transducteur un signal analogique tel une tension électrique. De manière classique, les capteurs numériques comprennent également un module de mise en oeuvre de gain et/ou décalage sur le signal analogique de sortie dudit transducteur, ainsi qu'un convertisseur analogique-numérique en sortie du capteur.

Le module de mise en oeuvre de gain et/ou décalage sur le signal analogique de sortie du transducteur permet de pouvoir utiliser un capteur numérique dans un environnement, tel un boîtier, dans lequel une perturbation externe modifie la grandeur physique à mesurer d'une manière relativement constante. Cela peut, par exemple, être le cas d'une perturbation d'un capteur magnétique intégré à un téléphone portable comprenant des haut-parleurs munis d'aimants puissants.

Dans le cas d'un capteur numérique, par exemple magnétique, illustré sur la figure 1, dont le fonctionnement nominal non perturbé est représenté sur la figure 2, lorsque celui-ci est intégré à un dispositif porteur constitué de composants amagnétiques, et dont le fonctionnement nominal lorsqu'il est intégré à un dispositif porteur embarquant des sources magnétiques, tel un téléphone portable, est illustré sur la figure 3, dans lequel ces sources magnétiques déplacent le point de fonctionnement du capteur de manière importante mais connue ou identifiable lors de la fabrication du capteur ou à divers moments de son temps d'utilisation.

Dans la suite de la description, les exemples illustrent des cas dans lesquels le capteur numérique est un magnétomètre, mais l'invention s'applique à tout type de capteur numérique.

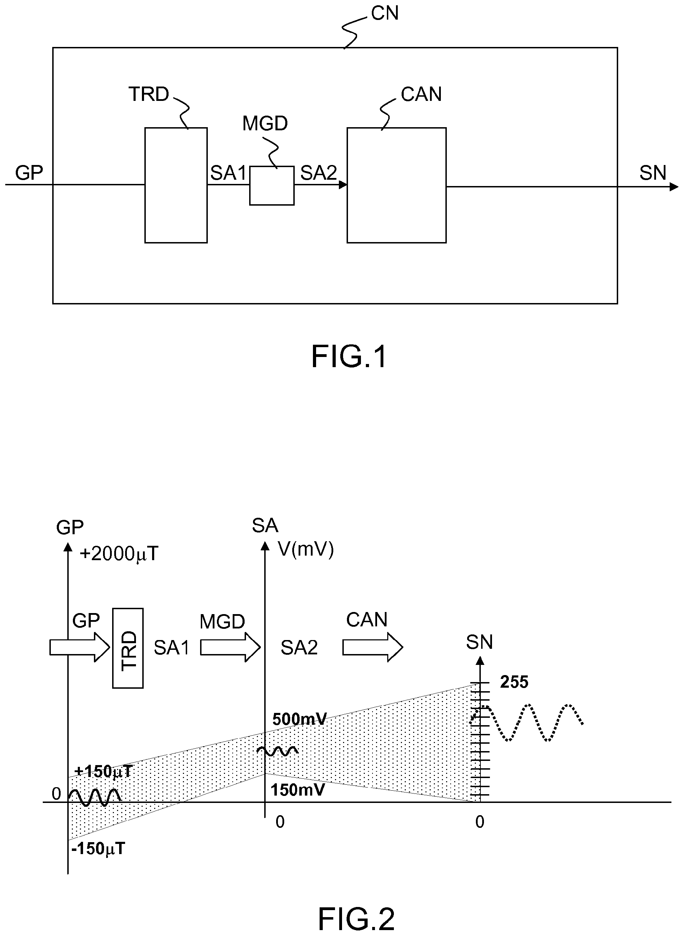

Sur la figure 1, le capteur numérique CN, en l'espèce un magnétomètre numérique, comprend un transducteur TRD délivrant en sortie un signal analogique SA1 représentatif de la grandeur physique mesurée GP. En l'espèce, le signal analogique SA1 en sortie du transducteur est une tension électrique. Le magnétomètre numérique CN comprend également un module MGD de mise en oeuvre de gain et/ou décalage sur le signal analogique SA1 de sortie dudit transducteur, pour transmettre un signal analogique SA2 à un convertisseur analogique-numérique CAN en sortie du capteur, pour délivrer un signal numérique SN en sortie du capteur numérique CN.

La figure 2 illustre le fonctionnement nominal non perturbé du magnétomètre numérique CN de la figure 1, par exemple lorsqu'il est inclus dans un boîtier amagnétique.

La grandeur physique mesurée GP, en l'espèce le champ magnétique, est le champ magnétique ambiant, non perturbé par un champ magnétique additionnel. Le signal analogique GP représentant la grandeur physique est modifié par le transducteur TRD en un signal analogique SA1, en l'occurrence une tension électrique, auquel est appliqué un gain et/ou décalage par le module MGD de mise en oeuvre de gain et/ou décalage, prédéterminé, dépendant du matériel utilisé, pour obtenir un signal analogique SA2 compris dans une plage de valeurs acceptables par le convertisseur analogique/numérique CAN. La plage de mesures de la grandeur physique GP utilisable par le transducteur TRD, en l'occurrence le champ magnétique, comprend des valeurs par exemple entre -150µT et 150µT, ce qui correspond pour équivalence en sortie du module MGD de mise en oeuvre de gain et/ou décalage et en entrée du convertisseur analogique/numérique CAN à une tension électrique SA2 comprise dans une plage de valeurs par exemple de 150mV à 500 mV. En sortie du convertisseur analogique/numérique CAN, le signal numérique SN correspondant, codé par exemple sur un octet, ou en d'autres termes sur 8 bits de données, peut prendre des valeurs entières comprises entre 0 et 256.

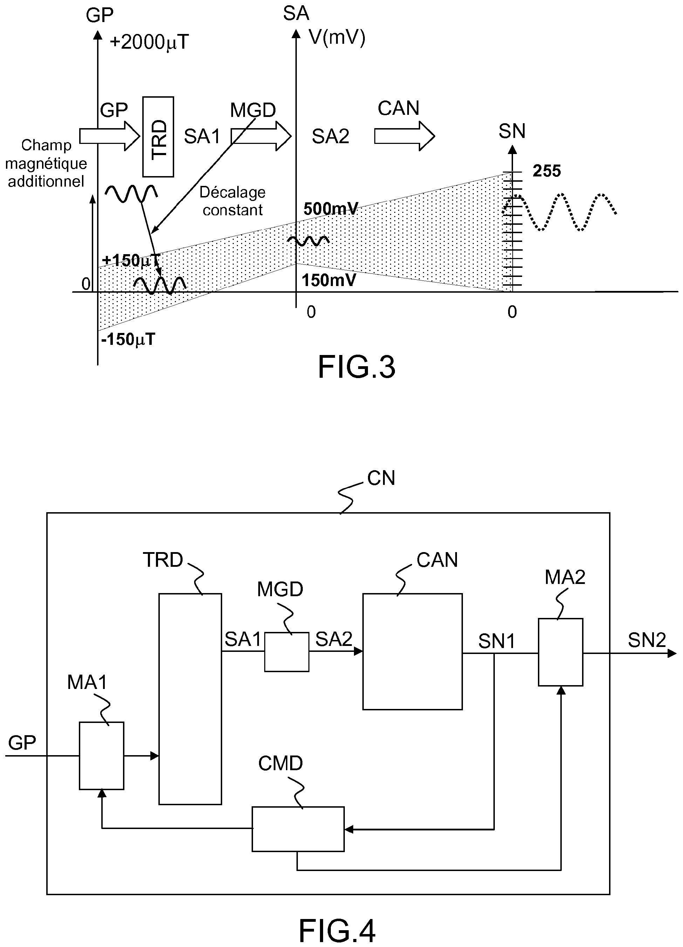

La figure 3 illustre le fonctionnement nominal perturbé du magnétomètre numérique CN de la figure 1, par exemple lorsqu'il est inclus dans un téléphone portable comprenant des haut-parleurs créant une perturbation magnétique prédéterminée.

La grandeur physique mesurée GP, en l'espèce le champ magnétique, est le champ magnétique ambiant, perturbé par un champ magnétique additionnel dû à des composants du téléphone portable capteur numérique étant soumis à un champ magnétique additionnel constant dû à des éléments du téléphone portable, tels des haut-parleurs, le module MGD de mise en oeuvre de gain et/ou décalage, applique en outre un décalage additionnel constant au signal GP, sensiblement égal à l'opposé du champ magnétique additionnel, de sorte que le signal analogique en entrée du capteur numérique CN soit décalé de manière à rester dans la plage de mesures du capteur numérique CN, i.e. du transducteur TRD.

Le document US 2008/291067 décrit un tel système de commande d'un capteur numérique. Les capteurs numériques peuvent toutefois saturer à cause d'un phénomène externe à celui de la mesure, faisant, par surprise, sortir la grandeur physique à mesurer de la plage de mesure du capteur.

Un but de l'invention est de pallier un tel problème.

Selon un aspect de l'invention, il est proposé un système de commande d'un capteur numérique de mesure d'une grandeur physique muni d'un transducteur délivrant en sortie un signal analogique représentatif de ladite grandeur physique, de moyens de mise en oeuvre de gain et/ou décalage sur le signal analogique de sortie dudit transducteur, et d'un convertisseur analogique-numérique en sortie du capteur pour délivrer un signal numérique. Le système comprend en outre:
- des premiers moyens d'application d'un premier décalage audit signal analogique de la grandeur physique,
- des deuxièmes moyens d'application d'un deuxième décalage audit signal numérique, et
- des moyens de commande pour commander en continu lesdits premiers moyens d'application, à partir dudit signal numérique, et pour commander en continu lesdits deuxièmes moyens d'application, à partir dudit signal numérique et/ou dudit premier décalage.

Ainsi, la présente invention permet d'éviter une saturation du capteur numérique lorsqu'une perturbation externe non prévue tend à faire sortir la grandeur physique mesurée de la plage de valeurs acceptée par le capteur numérique.

Selon un mode de réalisation, lesdits moyens de commande sont adaptés pour :
- calculer une différence entre le signal numérique en sortie dudit convertisseur et la valeur centrale de la plage de valeurs numériques possibles dudit signal numérique de sortie dudit convertisseur ;
- commander en continu lesdits premiers moyens d'application, en fonction de ladite différence ; et
- commander en continu lesdits deuxièmes moyens d'application en fonction de ladite différence.

Le système permet ainsi, en cas de brusque variation de la grandeur physique à mesurer par le capteur numérique, de sorte qu'elle risque de sortir de la plage de valeurs mesurable par le capteur numérique, le système décale le signal de sorte qu'il reste le plus possible centré dans ladite plage de valeurs, par centrage du signal numérique sur la plage de valeurs de sortie du capteur numérique.

Par exemple, ledit premier décalage peut être un multiple d'un décalage élémentaire dépendant de la sensibilité d'application du premier décalage par lesdits premiers moyens d'application.

Ainsi, l'instruction de décalage est donnée en une seule fois.

En variante, ledit premier décalage peut être réalisé par une succession de décalages élémentaires, le décalage élémentaire dépendant de la sensibilité d'application du premier décalage par lesdits premiers moyens d'application.

Ainsi, le décalage élémentaire peut être adapté à ladite sensibilité.

Dans un mode de réalisation, lesdits moyens de commande sont adaptés pour délivrer des signaux de commande à une fréquence sensiblement égale à la fréquence de conversion du capteur numérique.

Ainsi, le système de mesure a moins de risques de sortir de la fenêtre de numérisation, et le risque de saturation du capteur est limité car le signal est recentré à chaque pas de conversion.

En variante, lesdits moyens de commande sont adaptés pour délivrer des signaux de commande à une fréquence compatible avec la vitesse de variation du signal.

Ainsi, on adapte le processus de décalage pour qu'il consomme moins.

Selon un mode de réalisation de l'invention, lesdits moyens de commande comprennent une série d'instructions exécutables dans un microcontrôleur.

Selon un mode de réalisation, dans lequel lesdits premiers moyens d'application sont, en outre adaptés pour appliquer un premier gain audit signal analogique, et lesdits deuxièmes moyens d'application sont, en outre, adaptés pour appliquer un deuxième gain audit signal numérique.

Ainsi, en plus du décalage, un gain peut être également appliqué au signal d'entrée du capteur numérique pour le maintenir dans la plage de valeurs mesurables par le capteur numérique (dé-zoom, gain <1), ou pour augmenter la précision de la conversion (zoom, gain >1).

Par exemple, ledit signal analogique en sortie du transducteur est une tension électrique.

Dans un mode de réalisation, lesdits premier et deuxième décalages sont de signes opposés.

Selon un autre aspect de l'invention, il est également proposé un procédé de commande d'un capteur numérique de mesure d'une grandeur physique muni d'un transducteur délivrant en sortie un signal analogique représentatif de ladite grandeur physique, des moyens de mise en oeuvre de gain et/ou décalage sur le signal analogique de sortie dudit transducteur, et un convertisseur analogique-numérique en sortie du capteur pour délivrer un signal numérique, caractérisé en ce que :
- on applique un premier décalage audit signal analogique de la grandeur physique,
- on applique un deuxième décalage audit signal numérique, et
- on commande en continu ledit premier décalage, à partir dudit signal numérique, et on commande en continu ledit deuxième décalage, à partir dudit signal numérique et/ou dudit premier décalage.

L'invention sera mieux comprise à l'étude de quelques modes de réalisation décrits à titre d'exemples nullement limitatifs et illustrés par les dessins annexés sur lesquels :
- la figure 1 illustre un capteur magnétique numérique de l'état de l'art ;
- la figure 2 illustre le fonctionnement nominal non perturbé du magnétomètre numérique de la figure 1 ;
- la figure 3 illustre le fonctionnement nominal perturbé du magnétomètre numérique de la figure 1 ;
- la figure 4 illustre un capteur magnétique numérique, selon un aspect de l'invention ;

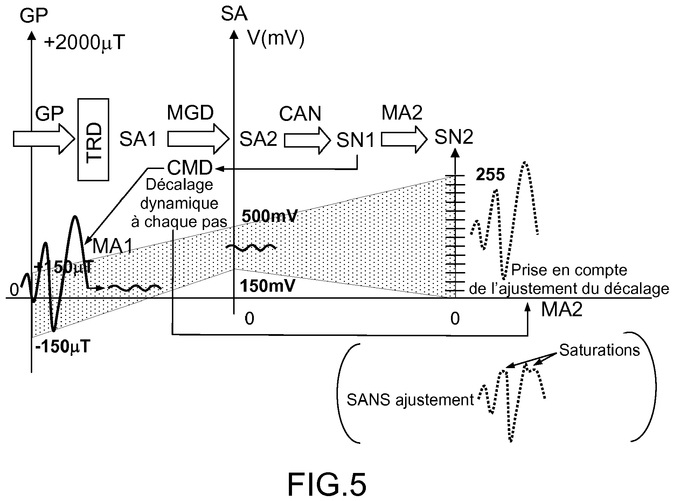

- la figures 5 illustre le fonctionnement du magnétomètre numérique de la figure 4, selon un aspect de l'invention ;

Sur les différentes figures, les éléments ayant des références identiques sont identiques.

Sur la figure 4, le capteur numérique CN, en l'espèce un magnétomètre numérique, comprend un transducteur TRD délivrant en sortie un signal analogique SA1 représentatif de la grandeur physique mesurée GP. En l'espèce, le signal analogique SA1 en sortie du transducteur est une tension électrique. Le magnétomètre numérique CN comprend également un module MGD de mise en oeuvre de gain et/ou décalage sur le signal analogique SA1 de sortie dudit transducteur, pour transmettre un signal analogique SA2 à un convertisseur analogique-numérique CAN en sortie du capteur, pour délivrer un signal numérique en sortie du capteur numérique CN.

Le signal numérique SN1 en sortie du convertisseur analogique-numérique CAN est transmis à un module de commande CMD, qui, en fonction de la valeur numérique du signal SN1 de sortie du convertisseur analogique-numérique CAN, commande en continu, ou, en d'autres termes, de manière dynamique, un premier module d'application MA1 d'un premier décalage audit signal analogique d'entrée du capteur CN ou grandeur physique GP à mesurer.

Cette commande en continu permet, en cas de perturbation non prévue de la grandeur physique GP à mesurer, en l'espèce le champ magnétique ambiant, tendant à faire quitter à celle-ci la plage de valeurs mesurables par le capteur CN, et plus particulièrement traitables par le transducteur TRD, d'appliquer un premier décalage ramenant ce signal analogique dans cette plage de valeurs.

En outre, après application d'un tel premier décalage, le module de commande CMD commande un deuxième module d'application MA2 d'un deuxième décalage au signal numérique SN1 de sortie du convertisseur analogique-numérique CAN, permettant d'avoir en sortie du magnétomètre numérique CN, une valeur affichée tenant compte du premier décalage qui a été appliqué en entrée pour éviter une saturation.

En variante, le premier module d'application MA1 est, en outre adapté pour appliquer un premier gain au signal analogique en entrée du capteur, et le deuxième module d'application est, en outre, adapté pour appliquer un deuxième gain au signal numérique en sortie du capteur CN.

La figure 5 illustre le fonctionnement d'un capteur de la figure 4, selon un aspect de l'invention.

Lorsqu'un champ magnétique additionnel perturbateur fait soudain sortir le champ magnétique à mesurer de la plage de valeurs possible, dans l'exemple la plage de valeurs [-150*µT*;150*µT*]. Lorsque le module de commande détecte que le signal numérique SN1 s'écarte de la valeur centrale de la plage de valeurs numériques codant le signal de sortie, en l'occurrence de la valeur 128, lorsque le signal numérique en sortie du convertisseur analogique/numérique CAN est codé sur un octet (8 bits), i.e. sur une plage de valeurs allant de 0 à 255, le module de commande CMD commande le premier module d'application de décalage, pour que celui-ci applique un décalage permettant de recentrer le signal analogique en entrée du magnétomètre, par application d'un décalage, de sorte qu'il reste dans la plage de mesure du capteur CN.

Le premier décalage effectué par le module de commande CMD et le premier module d'application MA1, peut être fait de différentes manières, par exemple par un décalage élémentaire constant successivement effectué, ou directement par le décalage nécessaire, pouvant être égal à un certain nombre de fois un décalage élémentaire. Le décalage élémentaire cité pourrait alors dépendre du matériel utilisé dans le capteur, et de sa finesse d'application d'un décalage minimal.

Un tel système permet, lorsque l'on utilise un capteur numérique, d'éviter une saturation de sa mesure, lorsqu'une perturbation de la grandeur physique à mesurer par le capteur numérique tend à faire sortir la grandeur physique à mesurer de la plage de valeurs mesurables par celui-ci.

## Revendications

1. Système de commande d'un capteur numérique (CN) de mesure d'une grandeur physique (GP) muni d'un transducteur (TRD) délivrant en sortie un signal analogique représentatif de ladite grandeur physique (GP), de moyens (MGD) de mise en oeuvre de gain et/ou décalage sur le signal analogique (SA1) de sortie dudit transducteur (TRD), et d'un convertisseur analogique-numérique (CAN) en sortie du capteur (CN) pour délivrer un signal numérique (SN1), et le système de commande comprenant :
des premiers moyens d'application (MA1) d'un premier décalage audit signal analogique de la grandeur physique (GP), **caractérisé en ce que** le système comprend:
des deuxièmes moyens d'application (MA2) d'un deuxième décalage audit signal numérique (SN1), et
des moyens de commande (CMD) pour commander en continu lesdits premiers moyens d'application (MA1), à partir dudit signal numérique (SN1), et pour commander en continu lesdits deuxièmes moyens d'application (MA2), à partir dudit signal numérique (SN1) et/ou dudit premier décalage.

2. Système selon la revendication 1, dans lequel lesdits moyens de commande (CMD) sont adaptés pour :
calculer une différence entre le signal numérique (SN1) en sortie dudit convertisseur (CAN) et la valeur centrale de la plage de valeurs numériques possibles dudit signal numérique de sortie dudit convertisseur (CAN) ;
commander en continu lesdits premiers moyens d'application (MA1), en fonction de ladite différence ; et
commander en continu lesdits deuxièmes moyens d'application (MA2) en fonction de ladite différence.

3. Système selon la revendication 1 ou 2, dans lequel ledit premier décalage est un multiple d'un décalage élémentaire dépendant de la sensibilité d'application du premier décalage par lesdits premiers moyens d'application (MA1).

4. Système selon la revendication 1 ou 2, dans lequel ledit premier décalage est réalisé par une succession de décalages élémentaires, le décalage élémentaire dépendant de la sensibilité d'application du premier décalage par lesdits premiers moyens d'application (MA1).

5. Système selon l'une des revendications 1 à 4, dans lequel lesdits moyens de commande (CMD) sont adaptés pour délivrer des signaux de commande à une fréquence sensiblement égale à la fréquence de mesure du capteur numérique (CN).

6. Système selon l'une des revendications 1 à 4, dans lequel lesdits moyens de commande (CMD) sont adaptés pour délivrer des signaux de commande à une fréquence compatible avec la vitesse de variation du signal.

7. Système selon l'une des revendications précédentes, dans lequel lesdits moyens de commande (CMD) comprennent une série d'instructions exécutables dans un microcontrôleur.

8. Système selon l'une des revendications précédentes, dans lequel lesdits premiers moyens d'application (MA1) sont, en outre adaptés pour appliquer un premier gain audit signal analogique, et lesdits deuxièmes moyens d'application (MA2) sont, en outre, adaptés pour appliquer un deuxième gain audit signal numérique.

9. Système selon l'une des revendications précédentes, dans lequel ledit signal analogique en sortie du transducteur (TRD) est une tension électrique.

10. Système selon l'une des revendications précédentes, dans lequel lesdits premier et deuxième décalages sont de signes opposés.

11. Procédé de commande d'un capteur numérique (CN) de mesure d'une grandeur physique (GP) muni d'un transducteur (TRD) délivrant en sortie un signal analogique (SA1) représentatif de ladite grandeur physique (GP), des moyens (MGP) de mise en oeuvre de gain et/ou décalage sur le signal analogique (SA1) de sortie dudit transducteur (TRD), et un convertisseur analogique-numérique (CAN) en sortie du capteur pour délivrer un signal numérique(SN1), dans lequel
on applique un premier décalage au signal analogique de la grandeur physique (GP),
**caractérisé en ce que** on applique un deuxième décalage audit signal numérique (SN1), et
on commande en continu ledit premier décalage, à partir dudit signal numérique (SN1), et on commande en continu ledit deuxième décalage, à partir dudit signal numérique (SN1) et/ou dudit premier décalage.

## Patentansprüche

1. System zum Steuern eines digitalen Sensors (CN) zum Messen einer physikalischen Größe (GP), ausgestattet mit einem Transducer (TRD) zum Liefern eines analogen Signals am Ausgang, das die physikalische Größe (GP) repräsentiert, Mittel (MGD) zum Implementieren einer Verstärkung und/oder einer Verschiebung an dem analogen Ausgangssignal (SA1) des Transducers (TRD), und mit einem Analog-DigitalWandler (CAN) am Ausgang des Sensors (CN) zum Liefern eines digitalen Signals (SN1), wobei das Steuersystem Folgendes umfasst:
erste Mittel (MA1) zum Anwenden einer ersten Verschiebung auf das analoge Signal der physikalischen Größe (GP),
**dadurch gekennzeichnet, dass** das System Folgendes umfasst:
zweite Mittel (MA2) zum Anwenden einer zweiten Verschiebung auf das digitale Signal (SN1); und
Steuermittel (CMD) zum kontinuierlichen Steuern der ersten Anwendungsmittel (MA1) auf der Basis des digitalen Signals (SN1) und zum kontinuierlichen Steuern der zweiten Anwendungsmittel (MA2) auf der Basis des digitalen Signals und/oder der ersten Verschiebung.

2. System nach Anspruch 1, wobei die Steuermittel (CMD) ausgelegt sind zum:
Berechnen einer Differenz zwischen dem digitalen Signal (SN1) am Ausgang des Wandlers (CAN) und dem zentralen Wert des Bereichs von möglichen digitalen Werten des digitalen Ausgangssignals des Wandlers (CAN);
kontinuierliches Steuern der ersten Anwendungsmittel (MA1) in Abhängigkeit von der Differenz; und
kontinuierliches Steuern der zweiten Anwendungsmittel (MA2) in Abhängigkeit von der Differenz.

3. System nach Anspruch 1 oder 2, wobei die erste Verschiebung ein Vielfaches einer elementaren Verschiebung ist, die von der Anwendungsempfindlichkeit der ersten Verschiebung durch die ersten Anwendungsmittel (MA1) abhängig ist.

4. System nach Anspruch 1 oder 2, wobei die erste Verschiebung von einer Folge von Elementarverschiebungen produziert wird, wobei die Elementarverschiebung von der Anwendungsempfindlichkeit der ersten Verschiebung durch die ersten Anwendungsmittel (MA1) abhängig ist.

5. System nach einem der Ansprüche 1 bis 4, wobei die Steuermittel (CMD) zum Liefern von Steuersignalen mit einer Frequenz, die im Wesentlichen gleich der Messfrequenz des digitalen Sensors (CN) ist, ausgelegt sind.

6. System nach einem der Ansprüche 1 bis 4, wobei die Steuermittel (CMD) zum Liefern von Steuersignalen mit einer Frequenz, die mit der Variationsgeschwindigkeit des Signals kompatibel ist, ausgelegt sind.

7. System nach einem der vorherigen Ansprüche, wobei die Steuermittel (CMD) eine Serie von Befehlen umfassen, die in einer Mikrosteuerung ausgeführt werden können.

8. System nach einem der vorherigen Ansprüche, wobei die ersten Anwendungsmittel (MA1) ferner zum Anwenden einer ersten Verstärkung auf das analoge Signal ausgelegt sind und die zweiten Signalanwendungsmittel (MA2) ferner zum Anwenden einer zweiten Verstärkung auf das digitale Signal ausgelegt sind.

9. System nach einem der vorherigen Ansprüche, wobei das analoge Signal am Ausgang des Transducers (TRD) eine elektrische Spannung ist.

10. System nach einem der vorherigen Ansprüche, wobei die erste und zweite Verschiebung entgegengesetzte Vorzeichen haben.

11. Verfahren zum Steuern eines digitalen Sensors (CN) zum Messen einer physikalischen Größe (GP), ausgestattet mit einem Transducer (TRD) zum Liefern eines analogen Signals (SA1) am Ausgang, das die physikalische Größe (GP) repräsentiert, Mittel (MGD) zum Implementieren einer Verstärkung und/oder einer Verschiebung auf das analoge Ausgangssignal (SA1) des Transducers (TRD) und einen Analog-DigitalWandler (CAN) am Ausgang des Sensors (CN) zum Liefern eines digitalen Signals (SN1), wobei:
eine erste Verschiebung auf das analoge Signal der physikalischen Größe (GP) angewendet wird,
**dadurch gekennzeichnet, dass** eine zweite Verschiebung auf das digitale Signal (SN1) angewendet wird und die erste Verschiebung auf der Basis des digitalen Signals (SN1) kontinuierlich gesteuert wird und die zweite Verschiebung auf der Basis des digitalen Signals (SN1) und/oder der ersten Verschiebung kontinuierlich gesteuert wird.

## Claims

1. A system for controlling a digital sensor (CN) for measuring a physical value (GP), provided with a transducer (TRD) supplying an analogue output signal representing said physical value (GP), means (MGD) for implementing gain and/or offset on the analogue output signal (SA1) of said transducer (TRD), and an analogue-digital converter (CAN) at the output of the sensor (CN) for supplying a digital signal (SN1), and the control system comprising:
first means (MA1) for applying a first offset to said analogue signal of the physical value (GP),
**characterised in that** the system comprises:
second means (MA2) for applying a second offset to said digital signal (SN1); and
control means (CMD) for continuously controlling said first application means (MA1), on the basis of said digital signal (SN1), and for continuously controlling said second application means (MA2), on the basis of said digital signal (SN1) and/or of said first offset.

2. The system as claimed in claim 1, wherein said control means (CMD) are adapted to:
compute a difference between the digital output signal (SN1) of said converter (CAN) and the central value of the range of possible digital values of said digital output signal of said converter (CAN);
continuously control said first application means (MA1) as a function of said difference; and
continuously control said second application means (MA2) as a function of said difference.

3. The system as claimed in claim 1 or 2, wherein said first offset is a multiple of an elementary offset dependent on the application sensitivity of the first offset by said first application means (MA1).

4. The system as claimed in claim 1 or 2, wherein said first offset is produced by a succession of elementary offsets, the elementary offset depending on the application sensitivity of the first offset by said first application means (MA1).

5. The system as claimed in any one of claims 1 to 4, wherein said control means (CMD) are adapted to supply control signals at a frequency that is substantially equal to the measurement frequency of the digital sensor (CN).

6. The system as claimed in any one of claims 1 to 4, wherein said control means (CMD) are adapted to supply control signals at a frequency that is compatible with the variation speed of the signal.

7. The system as claimed in any one of the preceding claims, wherein said control means (CMD) comprise a series of instructions that can be executed in a microcontroller.

8. The system as claimed in any one of the preceding claims, wherein said first application means (MA1) are also adapted to apply a first gain to said analogue signal and said second signal application means (MA2) are also adapted to apply a second gain to said digital signal.

9. The system as claimed in any one of the preceding claims, wherein said analogue output signal of the transducer (TRD) is an electric voltage.

10. The system as claimed in any one of the preceding claims, wherein said first and second offsets are of opposite signs.

11. A method for controlling a digital sensor (CN) for measuring a physical value (GP), provided with a transducer (TRD) supplying an analogue output signal (SA1) representing said physical value (GP), means (MGD) for implementing gain and/or offset on the analogue output signal (SA1) of said transducer (TRD) and an analogue-digital converter (CAN) at the output of the sensor (CN) for supplying a digital signal (SN1), wherein:
a first offset is applied to the analogue signal of the physical value (GP),
**characterised in that** a second offset is applied to said digital signal (SN1), and said first offset is continuously controlled, on the basis of said digital signal (SN1), and said second offset is continuously controlled, on the basis of said digital signal (SN1) and/or of said first offset.
